# EUROPÄISCHE PATENTSCHRIFT

(11) **EP 4 446 477 B1**
(45) Veröffentlichungstag und Bekanntmachung des Hinweises auf die Patenterteilung: **19.11.2025**
(21) Anmeldenummer: 24162954.2
(22) Anmeldetag: 12.03.2024
(51) Int. Cl.: C23C 14/02, C23C 14/18, C23C 14/34, C23C 14/58, C23C 4/06, C23C 4/12, C23C 18/08, C23C 18/10, C23C 18/12, C23C 20/04, C25D 11/08, C25D 11/10, C25D 11/26, C25D 11/30, C25D 11/34, C23C 4/08, C23C 4/11, C23C 4/134, C25D 11/02

(54) **VERFAHREN ZUM BESCHICHTEN EINES SUBSTRATS**
METHOD FOR COATING A SUBSTRATE
PROCÉDÉ DE REVÊTEMENT D'UN SUBSTRAT

(30) Priorität: 14.04.2023 DE 102023109420
(43) Veröffentlichungstag der Anmeldung: 16.10.2024
(73) Patentinhaber: Verein zur Förderung von Innovationen durch Forschung, Entwicklung und Technologietransfer e.V. (Verein INNOVENT e.V.), 07745 Jena (DE)
(72) Erfinder: TEUMER, Martin, 07616 Bürgel (DE); SCHMIDT, Jürgen, 07745 Jena (DE); XU, Jun, 07745 Jena (DE); BEIER, Oliver, 07407 Rudolstadt (DE); PFUCH, DR., Andreas, 99510 Apolda (DE)
(74) Vertreter: Liedtke & Partner Patentanwälte

(56) Entgegenhaltungen:
- DE-A1- 10 118 763
- DE-B3- 102014 211 385
- US-A1- 2010 209 594
- US-A1- 2014 335 651

## Beschreibung

Die Erfindung betrifft ein Verfahren zum Beschichten eines elektrisch leitenden oder nichtleitenden Substrats.

Für das Beschichten von leitenden und nichtleitenden Substraten im Allgemeinen sind verschiedene Verfahren etabliert. Grundsätzlich werden die folgenden Verfahrensprinzipien unterschieden.

### Physikalische Gasphasenabscheidung (PVD)

Die physikalische Gasphasenabscheidung beschreibt ein Verfahren der Dünnschichttechnologie, bei der ein über einen physikalischen Prozess in die Gasphase überführtes Material in einer meist luftleeren Beschichtungskammer auf der Werkstoffoberfläche kondensiert und damit zur Ausbildung von Funktionsschichten mit Dicken im Nano- oder Mikrometerbereich führt. Die einzelnen PVD-Verfahren unterscheiden sich vor allem durch die Methoden, mit denen die Beschichtungsstoffe in die Gasphase überführt und zu den Oberflächen transportiert werden, die beiden grundlegenden Prozesse sind dabei das Verdampfen und das Sputtern.

### Chemische Gasphasenabscheidung (CVD)

Die chemische Gasphasenabscheidung ist ein Verfahren der Dünnschichttechnologie, bei dem sich das zu beschichtende Werkstück und reaktionsfähige Gase in einer Reaktionskammer befinden. Das Werkstück wird elektrisch beheizt. Hat es eine bestimmte Temperatur erreicht, reagieren die Gase im Bereich der Werkstückoberfläche miteinander. Die Reaktionsprodukte setzen sich in Form von dünnen Schichten auf der Oberfläche ab und werden vom Material chemisch gebunden.

### Galvanische Verfahren

Unter Galvanotechnik versteht man die elektrochemische Abscheidung von metallischen Niederschlägen (Überzügen) auf Oberflächen.

### Plasmachemische Oxidation (PCO)

Mit dem Verfahren der plasmachemischen Oxidation (PCO) können auf den Leichtmetallen Aluminium, Titan, Magnesium und deren Legierungen anorganische röntgenamorphe Mischoxidschichten erzeugt werden. Diese enthalten neben oxidischen Verbindungen des Substratmaterials auch nichtstöchiometrische Verbindungen von Elektrolytbestandteilen.

### Thermisches Spritzen

Das thermische Spritzen umfasst plasma-, flamm- oder laserbasierte Verfahren, die zur Herstellung von Schichten mit Dicken im Mikrometerbereich genutzt werden und bei denen Spritzzusätze innerhalb oder außerhalb von Spritzgeräten an-, auf-oder abgeschmolzen und auf vorbereitete Oberflächen aufgeschleudert werden. Die Oberflächen werden dabei nicht aufgeschmolzen. Je nach Verfahren werden dabei unterschiedliche Temperaturen als auch Spritzgeschwindigkeiten erreicht, die den Beschichtungsprozess maßgeblich charakterisieren.

DE 101 18 763 A1 beschreibt, dass auf ein Substrat aus beliebigen, auch nicht elektrisch sperrschichtbildenden Materialien, wie Glas, Keramik, Glaskeramik, Eisen bzw. anderen Metallen, eine Zwischenschicht aus einem oder mehreren elektrisch sperrschichtbildenden Materialien, wie Magnesium, Aluminium, Titan, Tantal, Zirkonium, Wolfram etc. und/oder deren Legierungen, aufgebracht wird. Auf diese Zwischenschicht wird eine Metalloxid- bzw. Metallmischoxidschicht mit einer funktionellen bzw. dekorativen Oberflächenwirkung aufgebracht. Die Substratoberfläche kann dabei vor Aufbringung der Zwischenschicht aus Gründen der elektrischen Leitfähigkeit für den Sperrschichteffekt mit einer beliebigen Metallschicht überzogen werden. Das Verfahren findet Anwendung zur Herstellung von Schichtkörpern für unterschiedlichste Anwendungszwecke, beispielsweise elektronische, optische und katalytisch wirksame Verwendungen.

DE 10 2014 211 385 B3 beschreibt ein Verfahren zur Beschichtung eines Substrats umfassend ein Leichtmetall und/oder Molybdän und/oder Tantal, wobei die Schicht mittels plasmachemischer anodischer Oxidation in einem wässrigen Elektrolyten erzeugt wird, wobei der wässrige Elektrolyt umfasst:
- Ammoniumheptamolybdat oder Ammoniumheptamolybdathexyahydrat,
- Eisencitrat oder Ammoniumeisen(ill)citrat,
- einen Komplexbildner.

Der Erfindung liegt die Aufgabe zu Grunde, ein neuartiges Verfahren zum Beschichten eines Substrats anzugeben.

Die Aufgabe wird erfindungsgemäß gelöst durch ein Verfahren zum Beschichten eines Substrats gemäß Anspruch 1, insbesondere durch das Kaltplasmaspritzen oder ein vergleichbares Verfahren, mit dem eine Leichtmetallschicht auf einem Substrat erzeugt werden kann.

Vorteilhafte Ausgestaltungen der Erfindung sind Gegenstand der Unteransprüche.

Gemäß einem Aspekt der Erfindung wird bei einem Verfahren zum Beschichten eines Substrats auf dem Substrat mittels Plasmaspritzen, insbesondere Kaltplasmaspritzen, mindestens eine Schicht aus einem Metall, insbesondere einem Leichtmetall, oder einer Metalllegierung, insbesondere einer Leichtmetalllegierung, aufgebracht, wobei das aufgespritzte Leichtmetall bzw. die aufgespritzte Leichtmetalllegierung mittels anodischer Oxidation oder plasmachemischer Oxidation, beispielsweise unter Verwendung eines wässrigen Elektrolyten, der KH₂PO₄, Na₂CO₃ und C₆H₈O₇·nFe·nH₃N enthält, in eine oxidkeramische Schicht überführt wird, die beispielsweise in einem weiten Wellenlängenbereich optisch hochabsorbierend ist.

Alternativ zum Kaltplasmaspritzen lassen sich gemäß der Erfindung auch weitere Spritzmethoden, wie z.B. thermisches Plasmaspritzen, Kaltgasspritzen, Flammspritzen, Detonationsspritzen (engl. Detonation spraying), Laserspritzen, Lichtbogenspritzen oder Vakuumplasmaspritzen einsetzen, insbesondere im Falle temperaturstabiler Substratmaterialien. Als Ausgangsmaterial für den Spritzprozess dienen bevorzugt Feststoffpulver (Metall oder Metalllegierung), Dispersionen (Feststoffpulver in Flüssigmedien dispergiert) oder Lösungen. Letztere beide Varianten werden als Suspensions-Plasmaspritzen (engl. suspension plasma spraying - SPS) oder solution precursor plasma spraying (SPPS) bezeichnet. Bei Spritzmethoden mit höherem thermischem Eintrag (z.B. thermisches Plasmaspritzen, Flammspritzen, Laserspritzen, Lichtbogenspritzen) kann alternativ auch drahtförmiges Material (Metall oder Metalllegierung) verwendet werden. Der Vorteil des Kaltplasmaspritzens liegt in der Möglichkeit, dünne, haftfeste Schichten (Schichtdicken bis zu wenigen 10 µm) bei gleichzeitig moderatem Temperatureintrag in das Substratmaterial zu erzeugen. Somit lassen sich auch temperatursensible Kunststoffe wie Polypropylen oder Polyethylen oder Polymerfolien wie PET mittels Kaltplasmaspritzen beschichten. Durch die dünne Schicht wird ebenso die Gewichtszunahme des Substrats minimiert, wodurch dieses sich insbesondere für Leichtbauanwendungen eignet.

Das Verfahren des Kaltplasmaspritzens ist nicht auf Kunststoffe als Substratmaterialien beschränkt sondern beispielsweise auch auf Glas, Keramik, Metall (z.B. Stahl, Messing, Edelstahl) oder Verbundwerkstoffe anwendbar, die ohne eine zusätzliche Schicht (Metall, insbesondere ein Leichtmetall oder Metalllegierung, insbesondere eine Leichtmetalllegierung) nicht dem Prozess der anodischen Oxidation oder der plasmachemischen Oxidation zugänglich sind.

Bei einem nicht erfindungsgemäßen Verfahren zum Beschichten eines Substrats wird auf dem Substrat mittels physikalischer Gasphasenabscheidung mindestens eine Schicht aus einem Metall, beispielsweise einem Leichtmetall, oder einer Metalllegierung, beispielsweise einer Leichtmetalllegierung, aufgebracht, wobei das aufgedampfte Leichtmetall bzw. die aufgedampfte Leichtmetalllegierung mittels anodischer Oxidation oder plasmachemischer Oxidation in eine oxidkeramische Schicht überführt wird. Der Prozess der physikalischen Gasphasenabscheidung beschreibt ein Verfahren der Dünnschichttechnologie, bei der ein über einen physikalischen Prozess in die Gasphase überführtes Material in einer meist luftleeren Beschichtungskammer auf der Werkstoffoberfläche kondensiert und damit zur Ausbildung von Funktionsschichten mit Dicken im Nano- oder Mikrometerbereich führt. Die einzelnen PVD-Verfahren unterscheiden sich vor allem durch die Methoden, mit denen die Beschichtungsstoffe in die Gasphase überführt und zu den Oberflächen transportiert werden, die beiden grundlegenden Prozesse sind dabei das Verdampfen und das Kathodenzerstäuben (Sputtern). Als Verdampfungsprozesse zur Abscheidung einer Schicht aus einem Metall, insbesondere einem Leichtmetall oder einer Metalllegierung, insbesondere einer Leichtmetalllegierung können die Prozesse des Widerstandsverdampfens, des Elektronenstrahlverdampfens, des Induktionsverdampfens, des Lichtbogenverdampfens und der Laserablation verwendet werden. Als Kathodenzerstäubungsprozesse (Sputterprozesse) zur Abscheidung einer Schicht aus einem Metall, insbesondere einem Leichtmetall oder einer Metalllegierung, insbesondere einer Leichtmetalllegierung können Dioden-Zerstäubungsprozesse und Hochleistungs-Kathodenzerstäubungsprozesse (z.B. Magnetronsputtern, Hochenergieimpulsmagnetronsputtern - HiPIMS, DC-Sputtern, HF-Sputtern, Ionenstrahlsputtern) verwendet werden.

Der Vorteil von Verdampfungs- und Kathodenzerstäubungsprozessen liegt in der Möglichkeit, dünne, haftfeste Schichten (Schichtdicken im Bereich bis zu 5 µm) bei gleichzeitig moderatem Temperatureintrag in das Substratmaterial zu erzeugen. Somit lassen sich auch temperatursensible Kunststoffe wie Polypropylen oder Polyethylen oder Polymerfolien wie PET mittels Verdampfungs- und Sputterprozessen beschichten. Durch die dünne Schicht wird ebenso die Gewichtszunahme des Substrats minimiert, wodurch dieses sich insbesondere für Leichtbauanwendungen eignet.

Die Verfahren der physikalischen Gasphasenabscheidung sind nicht auf Kunststoffe als Substratmaterialien beschränkt, sondern beispielsweise auch auf Glas, Keramik, Metall (z.B. Stahl, Messing, Edelstahl) oder Verbundwerkstoffe anwendbar, die ohne eine erfindungsgemäße zusätzliche Schicht (Metall, insbesondere ein Leichtmetall oder Metalllegierung, insbesondere Leichtmetalllegierung) nicht dem Prozess der anodischen Oxidation oder der plasmachemischen Oxidation zugänglich sind.

Bei einem nicht erfindungsgemäßen Verfahren zum Beschichten eines Substrats wird auf dem Substrat mittels Drucktechnik mindestens eine Schicht aus einem Metall, beispielsweise einem Leichtmetall, oder einer Metalllegierung, beispielsweise einer Leichtmetalllegierung, aufgebracht, wobei das aufgedruckte Leichtmetall bzw. die Leichtmetalllegierung mittels eines nachgeschalteten Prozesses (beispielsweise Wärmeaushärtung z.B. Ofen, IR-Strahler, Blitzlampen - sog. Flash Lamp Annealing, oder Plasmen oder Flammen oder Laser) zu einer kompakten Schicht verdichtet und/oder versintert wird und anschließend mittels anodischer Oxidation oder plasmachemischer Oxidation in eine oxidkeramische Schicht überführt wird. Als Drucktechniken für die Schichtabscheidung sind folgende Methoden geeignet: Tintenstrahldruck, Laserdruck, LED-Druck, Sprühmethoden, Siebdruck, Tampondruck, Stempeldruck, Prägedruck oder Verfahren des 3D-Druckes. Als Ausgangsmaterial für den Druckprozess dienen chemische Vorläufersubstanzen, die als Lösung in Form von flüssigen Tinten vorliegen, oder auch Dispersionen oder Pasten (Feststoffpartikel in Flüssigmedien dispergiert) mit einem breiten Bereich an möglichen mittleren Partikelgrößen des Feststoffes, von wenigen Nanometern bis zu ca. 100 Mikrometern. Entsprechend liegen auch die resultierenden Schichtdicken in einem Bereich von ca. 0,01 µm bis 200 µm. In Abhängigkeit vom Substratmaterial, auf welches die Schicht aufgedruckt wurde, wird der nachgeschaltete Prozess ausgewählt. Beispielsweise eignen sich für temperatursensible Substrate wie Polypropylen oder Polyethylen oder Polymerfolien (bspw. PET), insbesondere das Flash Lamp Annealing, Plasmen im Niederdruck- oder Atmosphärendruckbereich mit niedrigem Temperatureintrag in das Substratmaterial sowie Flammenbehandlungen mit kurzen Interaktionszeiten (z.B. hohe Geschwindigkeiten). Die Verfahren der Drucktechniken sind nicht auf Kunststoffe als Substratmaterialien beschränkt, sondern beispielsweise auch auf Glas, Keramik, Metall (z.B. Stahl, Messing, Edelstahl) oder Verbundwerkstoffe anwendbar, die ohne eine erfindungsgemäße zusätzliche Schicht (Metall, insbesondere ein Leichtmetall oder Metalllegierung, insbesondere eine Leichtmetalllegierung) nicht dem Prozess der anodischen Oxidation oder der plasmachemischen Oxidation zugänglich sind. Durch die dünne Schicht wird ebenso die Gewichtszunahme des Substrats minimiert, wodurch dieses sich für Leichtbauanwendungen eignet.

In einer Ausführungsform wird als Leichtmetall Aluminium, Magnesium und/oder Titan, bzw. als Metall Zink, Wolfram, Molybdän, Tantal und/oder Niob oder eine Legierung, die mindestens eines der genannten Metalle enthält abgeschieden.

In einer Ausführungsform ist das Substrat aus einem thermoplastischen Kunststoff (z.B. PP, PE, PVC, ABS, PMMA, PS, PA6, PC, POM, PEEK, PTFE, ETFE, PET, PI Typ I, PI Typ II, PI Typ III), einem elastomeren Kunststoff (z.B. vernetztes Polyurethan, Silikonkautschuk) oder einem duroplastischen Kunststoff (z.B. Epoxidharz, Phenolharz, Melaninharz, Polyesterharz) gebildet.

In einer Ausführungsform ist das Substrat durch einen Verbundwerkstoff (z.B. GFK, CFK) gebildet.

In einer Ausführungsform ist das Substrat aus Glas gebildet.

In einer Ausführungsform ist das Substrat aus Keramik gebildet.

In einer Ausführungsform ist das Substrat aus Metall gebildet.

In einer Ausführungsform ist das Substrat aus additiv gefertigten Komponenten gebildet.

Die Schicht kann durch die plasmachemische Oxidation oder anodische Oxidation in eine elektrisch leitende, eine elektrisch isolierende, eine in einem weiten Wellenlängenbereich optisch hochabsorbierende, eine feuerfeste, eine biokompatible, eine antimikrobielle, eine korrosionsbeständige, eine besonders alterungsbeständige und/oder eine verschleißfeste oxidkeramische Schicht überführt werden.

Beispielsweise wird ein Bauteil bereitgestellt, umfassend ein Kunststoffsubstrat mit mindestens einer Schicht, die mittels des oben beschriebenen Verfahrens hergestellt wurde.

Beispielsweise kann die Verwendung des Bauteils im Elektrogerätebau, im optischen Gerätebau, in der Lasertechnik, in der Medizintechnik, in der Luftfahrt, in der Raumfahrt, in der Batterietechnik oder in der Akkumulatortechnik vorgesehen sein.

Ausführungsbeispiele der Erfindung werden im Folgenden anhand von Zeichnungen näher erläutert. Darin zeigen:

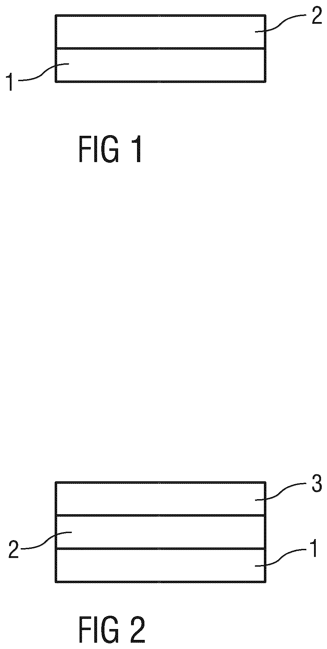

- Figur 1: eine schematische Ansicht eines einfachen Schichtaufbaus auf einem Kunststoffsubstrat, mit einer Schicht, die durch Abscheiden eines Metalls oder einer Metalllegierung, beispielsweise eines Leichtmetalls mittels eines Spritzprozesses, physikalischer Gasphasenabscheidung oder Drucktechnik und anschließender anodischer Oxidation oder plasmachemischer Oxidation erzeugt wurde, und
- Figur 2: eine schematische Ansicht eines mehrlagigen Schichtaufbaus auf einem Kunststoffsubtrat, mit zwei Schichten, die jeweils durch Abscheiden eines Metalls oder einer Metalllegierung, beispielsweise eines Leichtmetalls mittels eines Spritzprozesses, physikalischer Gasphasenabscheidung oder Drucktechnik und anschließender anodischer Oxidation oder plasmachemischer Oxidation erzeugt wurden.

Einander entsprechende Teile sind in allen Figuren mit den gleichen Bezugszeichen versehen.

Ein Aspekt der Erfindung betrifft oxidkeramische Schichtsysteme und ein Verfahren zu deren Herstellung auf Substraten, beispielsweise Kunststoffsubstraten, zum Zwecke der Funktionalisierung von Oberflächen. Für den Aufbau der Schichtsysteme wird auf dem Kunststoffsubstrat mittels eines Spritzprozesses, physikalischer Gasphasenabscheidung oder Drucktechnik, insbesondere durch Kaltplasmaspritzen, ein Metall, insbesondere ein Leichtmetall, beispielsweise Aluminium, Magnesium oder Titan, oder eine Legierung, die mindestens eines der genannten Metalle enthält (z.B. AlSi10Mg, Ti6Al4V, MgAl9Zn1) aufgebracht.

Anschließend wird das aufgespritzte Leichtmetall mittels anodischer Oxidation oder plasmachemischer Oxidation in eine oxidkeramische Schicht überführt. Die Temperaturbeständigkeit von Kunststoffen ist im Vergleich zu metallischen Werkstoffen relativ gering, sodass besondere Anforderungen an den Prozess der Plasmabeschichtung gestellt werden. Insbesondere soll der Plasmastrahl ein kalt geregelter Plasmastrahl sein. Aus diesem Grund werden die Kunststoffe mittels Kaltplasmaspritzen beschichtet. Durch das Nachschalten einer plasmachemischen Oxidation entstehen Schichtsysteme mit einem breiten Spektrum an Funktionalitäten, wie z.B. ein hohes optisches Absorptionsverhalten und eine verbesserte Verschleißbeständigkeit. Diese Funktionalitäten lassen sich maßgeblich über die Zusammensetzung der für die plasmachemische Oxidation eingesetzten wässrigen Elektrolyten einstellen. Verwendet man zum Beispiel einen wässrigen Elektrolyten, der unter anderem KH₂PO₄, Na₂CO₃ und C₆H₈O₇·nFe·nH₃N enthält, entstehen optisch hochabsorbierende Schichten. Überdies lässt sich durch eine gezielte Parametrierung der plasmachemischen Oxidation, insbesondere durch die Variation der Frequenz und einer damit einhergehenden sich verändernden Schichtmorphologie, dass Absorptionsverhalten weiter anpassen.

Für den Nachweis der technischen Machbarkeit wurden Flachsubstrate verschiedener Kunststoffe mit einer Kantenlänge von 100 mm sowohl einseitig als auch beidseitig beschichtet. Die plasmagespritzten Aluminiumschichten wurden im Anschluss mittels plasmachemischer Oxidation in oxidkeramische Schichten überführt. Die plasmachemische Oxidation wurde entsprechend dem Stand der Technik (Patent DE 10 2014 211 385 B3) in einem wässrigen Elektrolyten durchgeführt. In Abhängigkeit der Elektrolytzusammensetzung wurden schwarze oxidkeramische Schichten erzeugt.

Der Schichtaufbau wurde erfolgreich auf den folgenden Kunststoffen realisiert.
- Standardkunststoffe: PP, PE, PVC, ABS, PMMA, PS
- Technische Kunststoffe: PA6, PC, POM, PET
- Hochleistungskunststoffe: PI Typ I, PI Typ II, PI Typ III
- Verbundwerkstoffe: CFK, GFK.

In Abhängigkeit der verwendeten Beschichtungsmaterialen und der Schichtfolge lassen sich sowohl elektrisch leitende als auch elektrisch isolierende Schichtsysteme erzeugen.

Figur 1 ist eine schematische Ansicht eines einfachen Schichtaufbaus auf einem Kunststoffsubstrat 1, mit einer Schicht 2, die durch Abscheiden eines Metalls, insbesondere Leichtmetalls, mittels eines Spritzprozesses, physikalischer Gasphasenabscheidung oder Drucktechnik, insbesondere Kaltplasmaspritzen und anschließender anodischer Oxidation oder plasmachemischer Oxidation erzeugt wurde.

Figur 2 ist eine schematische Ansicht eines mehrlagigen Schichtaufbaus auf einem Kunststoffsubtrat mit zwei Schichten 2, 3, die jeweils durch Abscheiden eines Metalls, insbesondere Leichtmetalls, mittels eines Spritzprozesses, physikalischer Gasphasenabscheidung oder Drucktechnik, insbesondere Kaltplasmaspritzen und anschließender anodischer Oxidation oder plasmachemischer Oxidation erzeugt wurden.

Gegenüber dem Stand der Technik ergeben sich folgende Vorteile:
Das vorliegende Verfahren ermöglicht die Erzeugung von keramischen Schichten 2, 3 mit Schichtdicken zwischen 0,01 µm und 200 µm, bevorzugt zwischen 0,01 µm und 100 µm, besonders bevorzugt zwischen 0,01 µm bis 20 µm oder Schichtsystemen auf Substratmaterialien, wie Kunststoffen, Glas, Keramiken, Metallen oder Verbundwerkstoffen. Durch eine gezielte Funktionalisierung der Oberflächen von Kunststoffen können neue Anwendungsfelder für diese Kunststoffe erschlossen werden.

Mittels der erfindungsgemäß hergestellten Beschichtung lassen sich Schichten 2, 3 erzeugen, die beispielsweise in einem weiten Wellenlängenbereich optisch hochabsorbierend und/oder feuerfest entsprechend einschlägig bekannter Normen und/oder besonders alterungsbeständig, insbesondere gegenüber thermischer Beanspruchung, und/oder korrosionsbeständig und/oder verschleißfest und/oder biokompatibel und/oder antimikrobiell und/oder elektrisch leitend oder elektrisch isolierend sind. Dabei sind auch Kombinationsschichten realisierbar. Ferner ist auch eine partielle Beschichtung von Bauteilen möglich.

Es gibt zahlreiche Anwendungen für Kunststoffe, bei denen die Anforderungen an das Brandverhalten maßgeblich sind, beispielsweise beim Einsatz von Kunststoffen im Elektrogerätebau. Dabei gelten strenge Anforderungen und strikte Normen hinsichtlich des Brandverhaltens der eingesetzten Materialien. Mit dem erfindungsgemäßen Verfahren lassen sich Kunststoffbauteile mit feuerfesten Oberflächen ausstatten. Oxidkeramische Schichten besitzen einen ausgezeichneten Feuerwiderstand, sodass die funktionalisierten Kunststoffbauteile als Gehäusematerial für elektronische Anwendungen eingesetzt werden können.

Mit dem neuartigen Schichtsystem lassen sich stromableitende Oberflächen auf Kunststoffbauteilen erzeugen. Über die Schichtdicke können die elektrischen Eigenschaften der Schicht optimal auf die Anwendung angepasst werden. Solche Schichtsysteme werden zum Schutz von sensiblen elektronischen Komponenten im Gerätebau eingesetzt. Darüber hinaus werden elektrisch leitende Schichten zur Abschirmung von elektronischen Geräten gegenüber elektromagnetischen Feldern eingesetzt. Damit steht ein weiteres Verfahren zur EMV-Optimierung bzw. für den Blitzschutz von Kunststoffgehäusen zur Verfügung. Zudem lassen sich durch die Kombination von leitenden Aluminiumschichten und isolierenden PCO-Schichten weitere Funktionen integrieren.

Die Oberflächen von Kunststoffbauteilen sind im Einsatz verschiedenen Beanspruchungen ausgesetzt. Mit der Zeit nutzen sich Oberflächen ab, was unweigerlich zum Ausfall des Bauteils führt. Diese unerwünschte Erscheinung kann durch einen entsprechenden Verschleißschutz gebremst oder verhindert werden. Mit dem erfindungsgemäßen Verfahren lassen sich Kunststoffe (z.B. PP, PE, PMMA, PC, POM) mit speziellen Verschleißschutzschichten ausstatten, die vor allem dem thermischen Verschleiß, sprich Alterungsprozessen entgegenwirken und somit zur Verlängerung der Lebensdauer des Bauteils beitragen.

Mit dem beschriebenen Verfahren lassen sich auch Schichten 2, 3 für den Einsatz in der Batterie- und Akkumulatortechnik realisieren. Mittels Kaltplasmaspritzen kann beispielsweise eine Titanbeschichtung mit hoher Porosität bzw. spezifischer Oberfläche auf einem Substratträger (z.B. Polymerfolie) aufgebracht werden. Diese Titanschicht lässt sich mittels plasmachemischer Oxidation in eine poröse Titanoxidschicht oder eine zusätzlich dotierte Titanoxidschicht (z.B. dotiert mit SnO₂, MoS₂) überführen. An dieser hochporösen Schicht können sich z.B. Lithiumatome oder Lithiumionen in hoher Konzentration an- bzw. einlagern. Die so beschichteten Substratträger lassen sich als negative Elektrode in Lithium-Ionen-Akkumulatoren jeglicher Ausführung (z.B. LiFePO₄, LiFeYPO₄, Li(NiCoMn)O₂, LiPo, Li-Mn, LiCoO₂, LiCoO₂) einsetzen oder auch für zukünftige Akkumulatorgenerationen (z.B. Natrium-Ionen-Akkumulator, Aluminium-Ionen-Akkumulator). Ebenso ist eine zusätzliche Gewichtsreduktion der Akkumulatoren zu erzielen.

Alternativ zu einer Titanschicht kann auch Aluminium oder Magnesium mittels Kaltplasmaspritzen appliziert und durch plasmachemische Oxidation in eine reine oder zusätzlich dotierte Aluminiumoxidschicht bzw. Magnesiumoxidschicht überführt werden.

### Ausführungsbeispiel 1: Hochabsorbierende und reflexionsmindernde Schichtsysteme für Kunststoffe

Mit dem erfindungsgemäßen Verfahren lassen sich Kunststoffe mit hochabsorbierenden Oberflächen ausstatten. Es wurden Hochleistungskunststoffe des Typs Polyimid und Faserverbundwerkstoffe (CFK, GFK) erfolgreich mit schwarzen PCO-Schichten ausgestattet.

In einem ersten Schritt wurde mittels Kaltplasmaspritzen eine Aluminiumschicht auf den genannten Kunststoffen abgeschieden. Als Plasmaquelle diente ein InoCoat 3 System der Firma INOCON Technologie GmbH in Kombination mit einer Pulverdosierung vom Typ MediCoat FlowMotion. Reines Aluminiumpulver diente als Ausgangsmaterial und wurde mittels der Pulverdosierung direkt in den Plasmakopf eingespeist. Dabei wird das Pulver durch die Plasmaenergie primär an der Partikeloberfläche aufgeschmolzen und mit Hilfe des Prozessgasstromes (Argon) auf das Substrat 1 geschleudert, wo sich die Partikel schichtbildend anlagern. Der Medianwert x₅₀ der Partikelgröße des Aluminiumpulvers betrug 20,1 µm, analysiert mit einem Mastersizer 2000 Partikelgrößenmessgerät. Aus rasterelektronenmikroskopischen Untersuchungen wurde zudem ermittelt, dass das Pulver primär eine sphärische Form aufweist.

Die Beschichtung erfolgte mit folgenden Parametern auf dem Kunststoffen Polyimid bzw. den Verbundwerkstoffen CFK und GFK:
- Stromstärke: 120 bis 130 A (je nach Kunststoff)
- Prozessgas / Prozessgasfluss: Argon, 10 l/min
- Düse-Substrat-Abstand: 55 mm
- Verfahrgeschwindigkeit der Substrate: 150 mm/s
- Linienabstand: 5 mm
- Pulver: Al
- Dosierrate Al Pulver: ca. 3 g/min
- Trägergas / Trägergasfluss: Argon, 10 l/min
- Anzahl Beschichtungsdurchläufe 3.

Die resultierende Dicke (Höhenunterschied zwischen Schicht und Substrat 1) der Aluminiumschicht wurde mit dem Konfokalmikroskop MarSurf CM explorer der Firma MAHR GmbH zu ca. 40 µm bestimmt.

In einem zweiten Schritt wurde die mittels Kaltplasmaspritzen erzeugte Aluminiumschicht in einem wässrigen Elektrolyten plasmachemisch anodisch oxidiert (Schicht 2). An dieser Stelle sei auf das Patent mit dem Titel "Verfahren zur Beschichtung eines Substrats" mit der Nummer DE 10 2014 211 385 B3 verwiesen.

Der wässrige Elektrolyt umfasst die folgenden Bestandteile:
- Ammoniumheptamolybdat oder Ammoniumheptamolybdathexyahydrat,
- Eisencitrat oder Ammoniumeisen(III)citrat, und
- einen Komplexbildner.

Für die plasmachemisch anodische Oxidation wurde eine gepulste Stromversorgung der Firma plating electronic GmbH des Typs pe86CWD 500-53-120S verwendet. Die plasmachemisch anodische Oxidation wurde mit den folgenden Parametern durchgeführt:
- gepulster Gleichstrom mit einer Stromdichte von 0,05 A/dm² bis 15 A/dm²
- Spannungen von 200 V bis 500 V
- Elektrolyttemperatur von 15 °C bis 45 °C
- pH-Wert des Elektrolyten von 9,0 bis 11,0, insbesondere 10,2
- Leitfähigkeit des Elektrolyten von 20 mS/cm bis 40 mS/cm, insbesondere 33,7 mS/cm.

Die PCO-Schichten besitzen in einem breiten Wellenlängenbereich (ca. 400 nm - 2200 nm) eine geringe Gesamtreflektion ≤ 5 % und eignen sich aus diesem Grund insbesondere für Anwendungen im optischen Gerätebau bzw. der Lasertechnik. Auf Grundlage dessen sind Anwendungen in der Luft- und Raumfahrt denkbar, bei denen vor allem die Gewichtsersparnis eine entscheidende Rolle spielt (im Vergleich zu Aluminium ca. 20% leichter).

### Vergleichsbeispiel 2 : Biokompatible und antibakterielle Schichten für Implantatmaterialien

Für medizinische Anwendungen sind Beschichtungen erwünscht, um beispielsweise das Einwachsverhalten von Implantaten im menschlichen Körper sicherzustellen oder zu verbessern. Mit dem beschriebenen Verfahren lassen sich Implantatmaterialien (z.B. PEEK) mit einer Titanoxidschicht oder dotierten Titanoxidschicht versehen. In einem ersten Schritt kann mittels Kaltplasmaspritzen eine poröse Titanschicht bzw. Ti6Al4V-Schicht auf der Implantatoberfläche 1 erzeugt werden. An dieser Stelle sei auf die Patentschrift DE 10 2008 026 558 A1 verwiesen. Anschließend erfolgt mittels plasmachemischer Oxidation die Erzeugung einer zinkdotierten oder silberdotierten Titanoxidschicht (Schicht 2). Wie in der Patentschrift DE10 2008 046 198 B3 publiziert lassen sich Elektrolytbestandteile (insbesondere Calcium und Phosphor) in die aufwachsende Titanoxidschicht einlagern. Die erzeugten Oberflächen weisen im Vergleich zu einem unbeschichteten PEEK-Substrat verbesserte biokompatible und antibakterielle Eigenschaften auf.

### Vergleichsbeispiel 3: Hochabsorbierende und reflexionsmindernde Schichtsysteme für Glas

Mit dem beschriebenen Verfahren lässt sich Glas mit hochabsorbierenden Oberflächen ausstatten. Es wurden Floatglasprobekörper erfolgreich mit schwarzen PCO-Schichten ausgestattet.

In einem ersten Schritt wurde mittels dc-Kathodenzerstäuben (Sputtern) eine Aluminiumschicht auf dem Floatglas 1 abgeschieden. Als Beschichtungsquelle diente eine planare MAK-2"-Sputterkathode (Fa. US Inc.), als Target wurde ein 2" Aluminiumtarget verwendet. Vor der Sputter-Beschichtung wurde die Glasoberfläche mittels Sandstrahlen aufgeraut (Basic Quattro IS, Fa. Renfert; Strahlmittel 130 µm Korund, Fa. Hasenfratz) und für fünf Minuten in einer Isopropanol/Aceton-Mischung im Ultraschallbad (RK52H, Fa. Bandelin) gereinigt. Nach dem Einschleusen der Proben in die Vakuumkammer wurde diese auf einen Basisdruck von 5 x 10⁻⁶ mbar abgepumpt. Bei einem Argon-Arbeitsdruck von 1 x 10⁻³ mbar wurden unter Verwendung folgender Parameter dünne Aluminiumschichten auf die Floatglasproben abgeschieden:
- Abstand zwischen Probe und Kathode: 10 cm
- Plasmaleistung: 100 Watt
- Argonfluss: 20 sccm
- Beschichtungszeit: 20, 40 und 70 min.

Mit diesen Behandlungsparametern ergaben sich Aluminium-Schichtdicken, je nach Beschichtungszeit, von entsprechend 0,29 µm, 0,56 µm und 1,1 µm.

Im Anschluss an die PVD-Beschichtung wurde das abgeschiedene Aluminium mittels plasmachemischer Oxidation entsprechend Ausführungsbeispiel 1 in eine oxidkeramische Schicht 2 überführt.

### BEZUGSZEICHENLISTE

- 1: Substrat, Kunststoffsubstrat
- 2: Schicht
- 3: Schicht

## Patentansprüche

1. Verfahren zum Beschichten eines Substrats (1), wobei auf dem Substrat (1) mittels Kaltplasmaspritzen, thermischem Plasmaspritzen, Kaltgasspritzen, Flammspritzen, Detonationsspritzen, Laserspritzen, Lichtbogenspritzen oder Vakuumplasmaspritzen mindestens eine Schicht aus einem Metall oder einer Metalllegierung aufgebracht wird, wobei das Metall oder die Metalllegierung mittels plasmachemischer Oxidation unter Verwendung eines wässrigen Elektrolyten, der KH₂PO₄, Na₂CO₃ und C₆H₈O₇·nFe·nH₃N enthält, in eine in einem weiten Wellenlängenbereich optisch hochabsorbierende oxidkeramische Schicht (2, 3) überführt wird.

2. Verfahren nach Anspruch 1, wobei als Metall Zink, Wolfram, Molybdän, Tantal, Niob oder ein Leichtmetall, insbesondere Aluminium, Magnesium oder Titan oder eine Legierung eines oder mehrerer dieser Metalle, insbesondere Leichtmetalle, abgeschieden wird.

3. Verfahren nach Anspruch 1 oder 2, wobei das Substrat (1) aus einem thermoplastischen Kunststoff, einem elastomeren Kunststoff oder einem duroplastischen Kunststoff gebildet ist oder wobei ein Substrat (1) aus Glas, Keramik, Metall oder einem Verbundwerkstoff, insbesondere CFK oder GFK, beschichtet wird.

4. Verfahren nach Anspruch 3, wobei der thermoplastische Kunststoff aus PP, PE, PVC, ABS, PMMA, PS, PA6, PC, POM, PEEK, PTFE, ETFE, PET, PI Typ 1, PI Typ II, PI Typ III, gebildet ist oder wobei der elastomere Kunststoff aus vernetztem Polyurethan oder Silikonkautschuk gebildet ist oder wobei der duroplastische Kunststoff aus Epoxidharz, Phenolharz, Melaninharz oder Polyesterharz gebildet ist.

5. Verfahren nach einem der vorhergehenden Ansprüche, wobei das Substrat (1) aus additiv gefertigten Komponenten gebildet ist.

6. Verfahren nach einem der vorhergehenden Ansprüche, wobei als Ausgangsmaterial für den Spritzprozess ein Feststoffpulver aus einem Metall oder einer Metalllegierung, eine Dispersion eines Feststoffpulvers in einem flüssigen Medium, eine Lösung oder drahtförmiges Material aus einem Metall oder einer Metalllegierung verwendet wird.

## Claims

1. Method for coating a substrate (1), wherein cold plasma spraying, thermal plasma spraying, cold gas spraying, flame spraying, detonation spraying, laser spraying, electric arc spraying or vacuum plasma spraying is used to apply at least one layer of a metal or metal alloy on the substrate (1), wherein the metal or metal alloy is converted by means of plasma-chemical oxidation using an aqueous electrolyte containing KH₂PO₄, Na₂CO₃ and C₆H₈O₇ nFe nH₃N into an oxide-ceramic layer (2, 3) which is optically highly absorbent in a wide wavelength range.

2. Method according to Claim 1, wherein the metal deposited comprises zinc, tungsten, molybdenum, tantalum, niobium or a light metal, more particularly aluminium, magnesium or titanium, or an alloy of one or more of these metals, more particularly light metals.

3. Method according to Claim 1 or 2, wherein the substrate (1) is formed of a thermoplastic, an elastomeric plastic or a thermoset plastic or wherein a substrate (1) of glass, ceramic, metal or a composite material, more particularly CRP or GRP, is coated.

4. Method according to Claim 3, wherein the thermoplastic is formed of PP, PE, PVC, ABS, PMMA, PS, PA6, PC, POM, PEEK, PTFE, ETFE, PET, PI type 1, PI type II or PI type III or wherein the elastomeric plastic is formed of crosslinked polyurethane or silicone rubber or wherein the thermoset plastic is formed of epoxy resin, phenolic resin, melamine resin or polyester resin.

5. Method according to any of the preceding claims, wherein the substrate (1) is formed of additively manufactured components.

6. Method according to any of the preceding claims, wherein the starting material used for the spraying process is a solid powder of a metal or metal alloy, a dispersion of a solid powder in a liquid medium, a solution or wire-form material composed of a metal or metal alloy.

## Revendications

1. Procédé de revêtement d'un substrat (1), dans lequel au moins une couche d'un métal ou d'un alliage de métaux est appliquée sur le substrat (1) au moyen d'une pulvérisation au plasma froid, d'une pulvérisation au plasma thermique, d'une pulvérisation au gaz froid, d'une pulvérisation à la flamme, d'une pulvérisation par détonation, d'une pulvérisation au laser, d'une pulvérisation à l'arc électrique ou d'une pulvérisation au plasma sous vide, le métal ou l'alliage métallique étant transformé, au moyen d'une oxydation plasmachimique utilisant un électrolyte aqueux qui contient du KH₂PO₄, Na₂CO₃ et C₆H₈O₇ nFe nH₃N, en une couche de céramique oxydée (2, 3) à forte absorption optique dans une large plage de longueurs d'onde.

2. Procédé selon la revendication 1, dans lequel on dépose comme métal du zinc, du tungstène, du molybdène, du tantale, du niobium ou un métal léger, notamment de l'aluminium, du magnésium ou du titane ou un alliage d'un ou plusieurs de ces métaux, notamment de métaux légers.

3. Procédé selon la revendication 1 ou 2, dans lequel le substrat (1) est formé d'une matière thermoplastique, d'une matière plastique élastomère ou d'une matière plastique thermodurcissable, ou dans lequel un substrat (1) en verre, en céramique, en métal ou en un matériau composite, notamment en CFK ou en GFK, est revêtu.

4. Procédé selon la revendication 3, dans lequel la matière thermoplastique est formée de PP, PE, PVC, ABS, PMMA, PS, PA6, PC, POM, PEEK, PTFE, ETFE, PET, PI de type 1, PI de type II, PI de type III, ou dans lequel la matière élastomère est formée de polyuréthane réticulé ou de caoutchouc de silicone, ou dans lequel la matière plastique thermodurcissable est formée de résine époxy, de résine phénolique, de résine de mélanine ou de résine polyester.

5. Procédé selon l'une quelconque des revendications précédentes, dans lequel le substrat (1) est formé de composants fabriqués par fabrication additive.

6. Procédé selon l'une quelconque des revendications précédentes, dans lequel on utilise comme matériau de départ pour le processus de pulvérisation une poudre solide d'un métal ou d'un alliage de métaux, une dispersion d'une poudre solide dans un milieu liquide, une solution ou un matériau filiforme d'un métal ou d'un alliage de métaux.
